# EUROPEAN PATENT APPLICATION

(11) **EP 4 102 563 A1**
(43) Date of publication of application: **14.12.2022**
(21) Application number: 21926116.1
(22) Date of filing: 19.02.2021
(51) Int. Cl.: H01L 25/16, H01L 23/495

(54) **ENCAPSULATION STRUCTURE, POWER ELECTRICAL CONTROL SYSTEM AND MANUFACTURING METHOD**

(71) Applicant: Huawei Digital Power Technologies Co., Ltd., Shenzhen, Guangdong 518043 (CN)
(72) Inventor: LIU, Zhihua, Shenzhen, Guangdong 518129 (CN); CHEN, Huibin, Shenzhen, Guangdong 518129 (CN)
(74) Representative: Thun, Clemens
(86) International application number: PCT/CN2021/076928
(87) International publication number: WO 2022/174396

(57) **Abstract**

This application discloses a packaged structure, an electric power control system, and a manufacturing method. The packaged structure includes a first substrate and a second substrate. Power units are disposed on a first surface of the first substrate. A control unit is disposed on a first surface of the second substrate, and the second substrate is connected to one end of the first substrate. The control unit is electrically connected to the power units. The control unit is configured to: receive an external input signal, collect an internal sensing signal, and control the power units to work. The first surface of the second substrate is disposed on a same side as the first surface of the first substrate. When the structure is used, a signal part and a power part are integrated to meet product requirements for high integration and intelligence. In addition, the power units are disposed on the first substrate, and the control unit is disposed on the second substrate, so that the signal part and the power part can be separately disposed, to reduce thermal interference caused by the power part to the signal part during working, and prevent performance of the signal part from failing due to high temperature damage, thereby improving reliability, and prolonging a service life.

## Description

### TECHNICAL FIELD

This application relates to the field of electronic product technologies, and in particular, to a packaged structure, an electric power control system, and a manufacturing method.

### BACKGROUND

Due to large product power and high heat dissipation requirements of existing apparatuses such as an in-vehicle inverter, most of power modules of these apparatuses include only power chip parts and are further externally connected to integrated circuits, and therefore have relatively low integration and intelligence. There are a relatively long electric path, relatively great signal interference, a relatively large parasitic parameter between the power module of this structural form and another module. Consequently, a latency is long, and untimely protection is prone to occur. When the power module is applied to a high frequency, a loss is large, and oscillation is severe. In addition, an area of a circuit board required by the power module is also relatively large, and therefore product requirements for miniaturization and high reliability cannot be met. Furthermore, because a relatively large quantity of chips are integrated into the power module, electrodes on the chips need to be connected to pins on the circuit board through metal wire bonding, and conducting wires are numerous and dense. Consequently, there are risks such as wire sagging and a short-circuit due to wire sweep in a packaging process of the power module, affecting working reliability of the power module.

### SUMMARY

This application provides a packaged structure, to improve product integration and reliability of the packaged structure.

According to a first aspect, this application provides a packaged structure. The packaged structure includes a first substrate and a second substrate. Power units are disposed on a first surface of the first substrate. A control unit is disposed on a first surface of the second substrate, the second substrate is connected to one end of the first substrate, the control unit is electrically connected to the power units, and the control unit is configured to: receive an external input signal, collect an internal sensing signal, and control the power units to work. The first surface of the second substrate is disposed on a same side as the first surface of the first substrate.

In the technical solution provided in this application, the power units are a power part, the control unit is a signal part, the power units are disposed on the first substrate, the control unit is disposed on the second substrate, and the second substrate is connected to the first substrate, so that the signal part and the power part are integrated to meet product requirements for high integration and intelligence. In addition, the power units are disposed on the first substrate, and the control unit is disposed on the second substrate independent of the first substrate, so that the signal part and the power part can be separately disposed, to reduce thermal interference caused by the power part to the signal part during working, alleviate heat transmission and a temperature shock caused by a region in which the power part is located to a region in which the signal part is located, and prevent performance of the signal part from failing due to high temperature damage, thereby improving product reliability, and prolonging a product service life.

In a specific implementable solution, a plurality of rows of power units may be disposed on the first substrate, each row of power units includes at least one power unit arranged in a first direction, and power units in a same row may be electrically connected by using a first connecting part. The power units may be disposed in a plurality of rows, each row includes at least one power unit, and a plurality of power units are spaced as a whole, thereby helping improve heat dissipation efficiency of the power part.

When the first connecting part is specifically disposed, the first connecting part may include a conductor, and the conductor may be in a multi-arch bridge shape. The conductor includes a plurality of arch structures and a connecting part connected between adjacent arch structures, and the connecting part is electrically connected to the power unit. The power units in the same row are connected in parallel by using the conductor in the multi-arch bridge shape. Compared with a connection manner using metal wire bonding, the conductor is in a solid shape and is at a stable position after connection, so that neither wire sagging nor a short-circuit due to wire sweep is prone to occur, and reliability is high. In addition, the conductor has a low contact resistance, so that energy consumption is low. Furthermore, the conductor has simple connection and manufacturing processes.

In a specific implementable solution, the control unit is electrically connected to the power units by using a second connecting part, and the second connecting part may include at least one flexible printed circuit board. The control unit is connected to the power units by using the flexible printed circuit board, so that lines connected to the power units are symmetrically distributed, to optimize a line arrangement in which a plurality of power chips are connected in parallel, thereby achieving high layout symmetry. In addition, the flexible printed circuit board can ensure that the control unit is connected to the power units by using a relatively short line, to reduce a parasitic inductance; and further, can avoid wire sagging.

In a specific implementable solution, a conductive line may be arranged on the second substrate, and the flexible printed circuit board is electrically connected to the control unit by using the conductive line on the second substrate. Disposition of the conductive line facilitates an electrical connection between the flexible printed circuit board and the second substrate, and also facilitates an electrical connection between the control unit and the second substrate.

When a position relationship between the second substrate and the first substrate is specifically set, one end of the second substrate may be stacked on one end of the first substrate. The second substrate is stacked on the first substrate, so that a total length obtained after the second substrate is connected to the first substrate can be reduced, to reduce overall occupied space of the packaged structure in a horizontal dimension.

In a specific implementable solution, a second surface of the second substrate may be connected to the first surface of the first substrate, a first soldering part may be disposed on the second surface of the second substrate, a second soldering part may be disposed on the first surface of the first substrate, and the first soldering part is soldered to the second soldering part; or the first surface of the second substrate may be connected to a second surface of the first substrate, a first soldering part may be disposed on the first surface of the second substrate, a second soldering part may be disposed on the second surface of the first substrate, and the first soldering part is soldered to the second soldering part. The first soldering part and the second soldering part are disposed, so that the second substrate can be connected to the first substrate in a soldering manner, to achieve a convenient and reliable connection.

In addition to the manner of stacking the second substrate and the first substrate, another disposition manner may be alternatively used. For example, one end of the second substrate may be disposed against one end of the first substrate. The second substrate is disposed against the first substrate, so that a total height obtained after the second substrate is connected to the first substrate, to reduce overall occupied space of the packaged structure in a vertical dimension.

In a specific implementable solution, a first soldering part may be disposed on an end surface of the end that is of the second substrate and that is configured to abut against the first substrate, a second soldering part may be disposed on an end surface of the end that is of the first substrate and that is configured to abut against the second substrate, and the first soldering part is soldered to the second soldering part. Likewise, the first soldering part and the second soldering part are disposed, so that the second substrate is conveniently and reliably connected to the first substrate.

When the first soldering part and the second soldering part are specifically disposed, the first soldering part may be in a strip shape; the first soldering part may include a plurality of soldering bumps disposed in parallel; the second soldering part may be in a strip shape; or the second soldering part may include a plurality of soldering bumps disposed in parallel. Soldering parts in the strip shape are easier to align with each other, and can achieve a more stable connection between the two substrates. A soldering part formed by a plurality of soldering bumps disposed in a row can reduce solder used by the soldering part. The soldering part has two structural forms and therefore has high flexibility, so that diversified choices can be made based on an actual requirement.

In a specific implementable solution, a first lead part may be disposed at an end that is of the second substrate and that is away from the first substrate, and the first lead part is electrically connected to the control unit. A second lead part may be disposed at an end that is of the first substrate and that is away from the second substrate, and the second lead part is electrically connected to the power units. Disposition of the lead parts facilitates an electrical connection between the packaged structure and an external element.

When the first lead part and the second lead part are specifically disposed, an end that is of the first lead part and that is away from the second substrate may be in a planar shape or a step shape, and an end that is of the second lead part and that is away from the first substrate may be in the planar shape or the step shape. The lead part has two structural forms and therefore has high flexibility, so that diversified choices can be made based on an actual requirement. A lead part in the planar shape has a short connecting line. A lead part in the step shape facilitates structural fitting between the packaged structure and a peripheral element, thereby facilitating integration between the packaged structure and another element.

In a specific implementable solution, the first substrate may be a ceramic substrate or a brazed substrate with a conductive material on both sides. This type of substrate has relatively good thermal conductivity, and therefore using this type of substrate as the first substrate can improve heat dissipation efficiency of the power chip. In addition, this type of substrate is relatively heat-resistant, so that this type of substrate can be adapted to a high-temperature usage scenario; and further, a circuit can be arranged on this type of substrate.

In a specific implementable solution, the second substrate may be a printed circuit board, or the second substrate may be a ceramic substrate or a brazed substrate with a conductive material on both sides. Using this type of substrate as the second substrate facilitates arrangement of a conductive line between elements. This type of substrate also has relatively good thermal conductivity, so that this type of substrate can be adapted to a high-temperature usage scenario.

In a specific implementable solution, the power unit may include a power chip, and a surface that is of the power chip and that has a pin may be away from the first substrate. An opposite surface of the surface that is of the power chip and that has the pin is a main heat dissipation region of the power chip, and the surface that is of the power chip and that has the pin is away from the first substrate. That is, the power chip is installed on the first substrate in a bond pad up manner, so that the main heat dissipation region of the power chip is directly in contact with the first substrate with high heat conductivity, thereby facilitating heat dissipation of the power chip.

In a specific implementable solution, the control unit may include a control chip, and a surface that is of the control chip and that has a pin may face the second substrate. That is, the control chip is installed on the second substrate in a bond pad flip manner. This installation manner can shorten a wiring line, reduce signal interference, reduce a parasitic parameter, shorten a signal latency, and ensure a quick circuit response and a timely protection function response; and further, can avoid risks such as wire sagging due to a dense cable layout and a short-circuit due to wire sweep.

In addition, to accelerate heat dissipation of the control chip, a heat dissipation element may be disposed on a surface that is of the control chip and that is away from the second substrate. Disposition of the heat dissipation element can improve heat dissipation efficiency of the control chip, thereby helping ensure performance and a service life of the control chip.

In addition to the control chip, the control unit may further include a drive chip, and a surface that is of the drive chip and that has a pin faces the second substrate. Likewise, the drive chip is installed on the second substrate in the bond pad flip manner. This can shorten a wiring line, reduce signal interference, reduce a parasitic parameter, shorten a signal latency, and ensure a quick circuit response and a timely protection function response; and further, can avoid risks such as wire sagging due to a dense cable layout and a short-circuit due to wire sweep.

In a specific implementable solution, the packaged structure may further include a housing. The housing has accommodation space inside, and the first substrate and the second substrate are located inside the housing. The housing wraps the first substrate, the second substrate, and elements on the two substrates, and therefore can protect the wrapped elements and stabilize a connection between the elements.

When the housing is specifically disposed, a region that is on the housing and that corresponds to the second surface of the first substrate may have a first notch; and a region that is on the housing and that corresponds to the control unit may have a second notch. Disposition of the notches helps accelerate partial heat dissipation of the packaged structure.

In a specific implementable solution, a first heat sink may be disposed on the second surface of the first substrate; and a second heat sink may be disposed on a surface that is of the control unit and that faces away from the second substrate. Similarly, disposition of the heat sinks helps accelerate heat dissipation of the elements.

According to a second aspect, this application provides an electric power control system, including the foregoing packaged structure. The packaged structure is configured to convert a direct current of a battery into an alternating current to supply the alternating current to a power apparatus. The electric power control system is controlled by a central control system, for example, a central control system of an electric vehicle. In addition, the electric power control system is also intelligent, and has high working reliability.

According to a third aspect, this application provides a manufacturing method for a packaged structure, including:
installing a control unit on a first surface of a second substrate, so that the control unit is electrically connected to a conductive line arranged on the second substrate;
disposing a first soldering part at one end of the second substrate, disposing a second soldering part at one end of a first substrate, and soldering the first soldering part to the second soldering part, so that the second substrate and the first substrate are connected to become a whole;
electrically connecting, by using a second connecting part, power units disposed on the first substrate to the conductive line arranged on the second substrate, so that the power units are electrically connected to the control unit; and
plastically packaging the first substrate and the second substrate that are connected to become the whole.

In the technical solutions provided in this application, the second substrate can be connected to the first substrate, so that a signal part and a power part are integrated to meet product requirements for high integration and intelligence. In addition, the power units are disposed on the first substrate, and the control unit is disposed on the second substrate independent of the first substrate, so that the signal part and the power part are separately disposed, to reduce heat interference caused by the power part to the signal part during working, alleviate heat transmission and a temperature shock caused by a region in which the power part is located to a region in which the signal part is located, and prevent performance of the signal part from failing due to high temperature damage. The manufactured packaged structure has high integration, high reliability, and a long service life.

### BRIEF DESCRIPTION OF DRAWINGS

FIG. 1 is a schematic diagram of a three-dimensional structure of a packaged structure according to an embodiment of this application;
FIG. 2 is a schematic diagram of a structure of a first surface of a first substrate in a packaged structure according to an embodiment of this application;
FIG. 3 is a schematic diagram of a side-view structure of a first substrate in a packaged structure according to an embodiment of this application;
FIG. 4 is a schematic assembly diagram of a control chip and a second substrate in a packaged structure according to an embodiment of this application;
FIG. 5 is a schematic diagram of a structure of a first surface of a second substrate in a packaged structure according to an embodiment of this application;
FIG. 6 is a schematic diagram of a connection relationship between a first substrate and a second substrate in a packaged structure according to an embodiment of this application;
FIG. 7 is a schematic diagram of a disposition position of a soldering part in a packaged structure according to an embodiment of this application;
FIG. 8 is a schematic diagram of a structure of a soldering part in a packaged structure according to an embodiment of this application;
FIG. 9 is a schematic diagram of another structure of a soldering part in a packaged structure according to an embodiment of this application;
FIG. 10 is a schematic diagram of another connection relationship between a first substrate and a second substrate in a packaged structure according to an embodiment of this application; and
FIG. 11 is a flowchart of a manufacturing method for a packaged structure according to an embodiment of this application.

### Reference numerals:

100-first substrate; 200-second substrate; 300-first connecting part; 400-second connecting part; 500-first soldering part; 600-second soldering part; 700-first lead part; 800-second lead part; 900-heat dissipation element; 000-housing; 110-power unit; 210-control unit; 220-chip carrier; 310-conductor; 111-power chip; 211-control chip; 212-drive chip.

### DESCRIPTION OF EMBODIMENTS

The following describes in detail embodiments of this application with reference to accompanying drawings.

For ease of understanding, an application scenario of a packaged structure that the embodiments of this application relate is first described. The packaged structure provided in the embodiments of this application is adaptable to an electric control system, for example, an in-vehicle electric power control system. The packaged structure may be specifically integrated into an electric vehicle, for example, may be used as a three-phase full-bridge inverter of a motor drive controller, to convert a direct current of a battery into an alternating current and then supply the alternating current to a motor. An existing packaged structure for a power module has only a power part, and therefore has relatively low integration and intelligence. In addition, the power part is electrically connected to a circuit board through metal wire bonding. On one hand, because a metal wire has a relatively large quantity of wire types and wire diameter types, there are a relatively large quantity of manufacturing process steps and device investments, causing not only relatively low manufacturing efficiency but also a relatively high failure rate. On the other hand, because a relatively large quantity of chips are integrated into the power part, when electrodes on the chips are connected to pins on the circuit board through metal wire bonding, a relatively large quantity of conducting wires are used and densely arranged. Consequently, there are risks such as wire sagging and a short-circuit due to wire sweep in a packaging process.

Based on this, the embodiments of this application provide a packaged structure. The packaged structure can package a signal part and a power part together, and therefore has relatively high product integration. In addition, in the packaged structure, the power part and the signal part are separately disposed, so that thermal interference caused by the power part to the signal part can be reduced, thereby improving product working reliability.

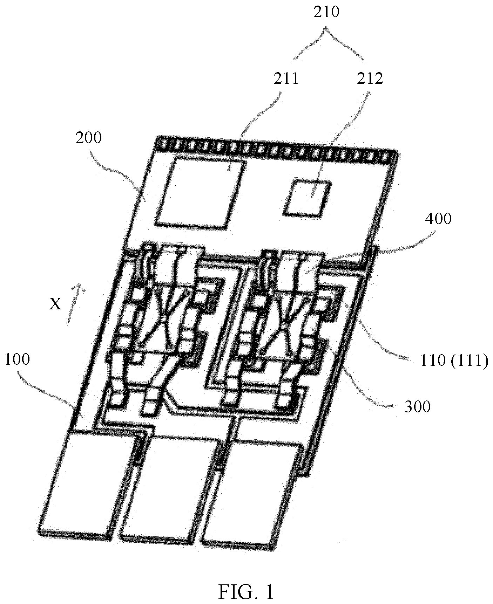

First, refer to FIG. 1. FIG. 1 is a schematic diagram of a three-dimensional structure of a packaged structure according to an embodiment of this application. As shown in FIG. 1, as an optional embodiment of this application, the packaged structure may include a first substrate 100 and a second substrate 200. A plurality of spaced power units 110 are disposed on a first surface of the first substrate 100. The plurality of power units 110 may be electrically connected by using a first connecting part 300. The plurality of power units 110 constitute a power part of a power module as a whole. The second substrate 200 is connected to one end of the first substrate 100. A control unit 210 is disposed on a first surface of the second substrate 200. The control unit 210 may be electrically connected to the power units 110 by using a second connecting part 400. The control unit 210 is a signal part of the power module.

In this embodiment, the power units 110 are disposed on the first substrate 100, the control unit 210 is disposed on the second substrate 200, and the second substrate 200 is connected to the first substrate 100, so that the signal part and the power part are integrated to meet product requirements for high integration and intelligence. In addition, the first substrate 100 and the second substrate 200 are independent of each other, so that the signal part and the power part can be separately disposed, to reduce thermal interference caused by the power part to the signal part during working, alleviate heat transmission and a temperature shock caused by a region in which the power part is located to a region in which the signal part is located, and prevent performance of the signal part from failing due to high temperature damage, thereby improving product reliability, and prolonging a product service life.

The plurality of power units 110 may be of an evenly-spaced and symmetrical spatial layout structure. During specific implementation, the plurality of power units 110 may be arranged into a plurality of rows in a direction from one end of the first substrate 100 to the other end of the first substrate 100 at a same row spacing, and there may be at least two power units 110 in each row. The direction from one end of the first substrate 100 to the other end of the first substrate 100 is defined as a first direction x, and the plurality of rows of power units 110 may be symmetrically distributed with respect to a midline of the first substrate 100 in the first direction. Power units 110 in a same row may be electrically connected by using one first connecting part 300.

During specific implementation, the power units 110 may be power chips 111. A metal-oxide-semiconductor field-effect transistor (metal-oxide-semiconductor field-effect transistor, MOSFET) may be selected as the power chip 111. For example, the power chip 111 may be specifically a silicon (Si), silicon carbide (SiC), or gallium nitride (GaN) MOSFET. The control unit 210 may include a control chip 211. For example, the control chip 211 may be an application-specific integrated circuit (application specific integrated circuit, ASIC) chip, or a digital signal processing (digital signal processing, DSP) chip. The control unit 210 may further include a drive chip 212. In this case, both the control chip 211 and the drive chip 212 may be disposed on the second substrate 200. When both the control chip 211 and the drive chip 212 are disposed on the second substrate 200, the control chip 211 may be configured to receive an external input signal, for example, a control signal. After the control signal is processed by the control chip 211, a processed signal is sent to the drive chip 212. The drive chip 212 performs processing such as amplification, isolation, and filtering on the signal, and then sends a processed signal to the power chips 111 by using the second connecting part 400, to control the plurality of power chips 111 to execute a power-on instruction, a power-off instruction, or the like. The control chip 211 is also configured to: collect temperature information of the power chips 111, temperature information of a chip-related accessory on the first substrate 100, and current information of the power chips 111; and send the collected initial information, or perform processing and determining on the collected initial information and then send information obtained after the processing and determining.

A high thermal conductivity substrate with a relatively thick conductive material on both sides may be used as the first substrate 100, to adapt to a high-temperature usage scenario. For example, the first substrate 100 may be specifically a direct bond copper (direct bond ceramic, DBC) ceramic substrate, a direct bond aluminum (direct bond aluminum, DBA) ceramic substrate, an active metal brazing (active metal brazing, AMB) aluminum nitride (AlN) or silicon nitride (Si₃N₄) ceramic substrate, or a zirconia toughened alumina (zirconia toughened alumina, ZTA) direct bond copper (ZTADBC) ceramic substrate. A thickness of a surface copper layer of the first substrate 100 is optionally 0.1 mm to 1.2 mm. For example, the thickness of the surface copper layer may be 0.1 mm, 1.05 mm, or 1.2 mm. For example, a printed circuit board (printing circuit board, PCB) may be used as the second substrate 200. Alternatively, the foregoing DBC or DBA ceramic substrate, a direct plating copper (direct plating ceramic, DPC) ceramic substrate, or the like may be used as the second substrate 200. A double-sided conductive material of the second substrate 200 may be thinner than that of the first substrate 100.

During specific implementation, a first conductive line is arranged on the first substrate 100, and a half-bridge circuit may be used as the first conductive line. The power chips 111 are electrically connected to the first conductive line arranged on the first substrate 100, thereby connecting the plurality of power chips 111 in parallel. The power chip 111 may be installed on the first substrate 100 in a bond pad up manner, that is, a surface that is of the power chip 111 and that has a pin is disposed away from the first substrate 100. During specific implementation, the power chip 111 may be fastened to the first substrate 100 through adhering.

In this embodiment, a flexible printed circuit board (flexible printing circuit board, FPC) may be used as the second connecting part 400. Based on the foregoing description, the PCB may be used as the second substrate 200, and the second connecting part 400 is electrically connected to the second substrate 200, that is, the FPC is electrically connected to the PCB. The power chips 111 may be electrically connected to the second substrate 200 by using cables laid out on the second connecting part 400, to be electrically connected to the control chip 211 by using cables laid out on the second substrate 200. Compared with a conducting wire connection manner, in this embodiment, the cables are laid out on the FPC, so that symmetrical line distribution can be implemented. The cable layout is not limited to laying out cables along a straight line. Therefore, the second connecting part 400 can be equidistantly connected to the power chips 111, to optimize a line arrangement in which the plurality of power chips 111 are connected in parallel, thereby achieving high layout symmetry. In addition, because the FPC can be manufactured into a regular plate-like structure, the control unit 210 can be connected to the power units 110 by using a relatively short line, to reduce a parasitic inductance; and further, a wire sagging risk can be reduced.

During specific implementation, the second connecting part 400 may be of a single-layer plate structure, or may be of a stacked multi-layer plate structure, and may be specifically designed based on a quantity of arranged lines. This is not limited in this application. A substrate of the second connecting part 400 may be made of a resinous material or a polyimide (polyimide, PI) material. In addition, the second connecting part 400 may be one integral FPC, or may include a plurality of FPCs, and may be specifically designed based on an internal layout of the packaged structure. This is also not limited in this application.

With reference to the foregoing embodiment, arrangement and connection of the power chips 111 are described by using an example in which eight power chips 111 are included. The eight power chips 111 may be divided into two groups, each group may include four power chips 111, and drains of the two groups of power chips 111 are electrically connected by using the half-bridge circuit on the first substrate 100. In addition, the four power chips 111 in each group may be arranged into two rows, and sources of power chips 111 in each row are electrically connected by using one first connecting part 300. Gates of power chips 111 in a same group are further electrically connected to a second conductive line on the second substrate 200 by using the second connecting part 400, so that all the power chips 111 are electrically connected to the control chip 211 and the drive chip 212, and the control chip 211 can control all the power chips 111 to execute a power-on instruction, a power-off instruction, or the like.

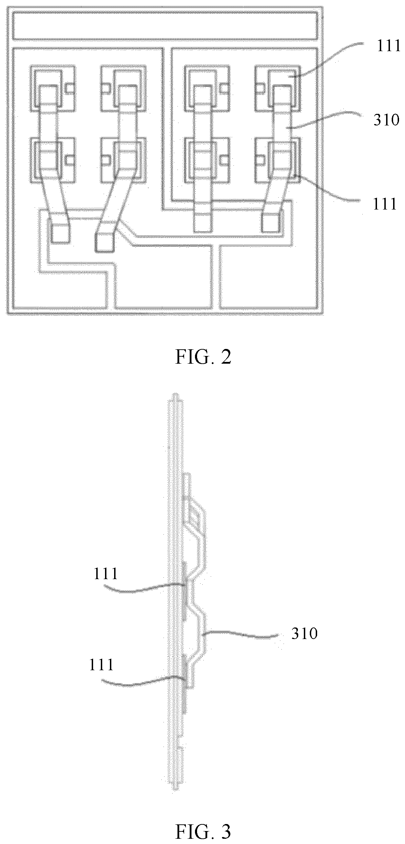

Next, refer to FIG. 2 and FIG. 3. FIG. 2 is a schematic diagram of a structure of the first surface of the first substrate in the packaged structure according to an embodiment of this application. FIG. 3 is a schematic diagram of a side-view structure of the first substrate in the packaged structure according to an embodiment of this application. In the embodiments of this application, a conductor 310 may be used as the first connecting part. The conductor 310 may connect the plurality of power chips 111 together in parallel to meet requirements for power-on/off and heat dissipation. Compared with a manner in which a power chip 111 is electrically connected to a substrate through metal wire bonding in the conventional technology, in this embodiment, the conductor 310 is in a solid shape and is at a stable position after connection, so that wire sagging or a short-circuit due to wire sweep is not likely to occur, and reliability is relatively high. In addition, the conductor 310 has simple installation and manufacturing processes, and therefore also has relatively low manufacturing costs. Furthermore, the conductor 310 also has a relatively low contact resistance, thereby helping reduce energy consumption of the power part.

During specific implementation, the conductor 310 may be in a multi-arch bridge shape. The conductor 310 may include a plurality of arch structures and a connecting part connected between adjacent arch structures, and the connecting part may be configured to be connected to the power chip 111. During specific disposition, a soldering joint may be disposed on the connecting part, so that the conductor 310 can be electrically connected to the pin of the power chip 111 in a soldering manner. A material of the conductor 310 is not limited, for example, may be copper, copper-aluminum alloy, or copper-molybdenum alloy, or may be a material such as silicon carbide aluminum (AlSiC).

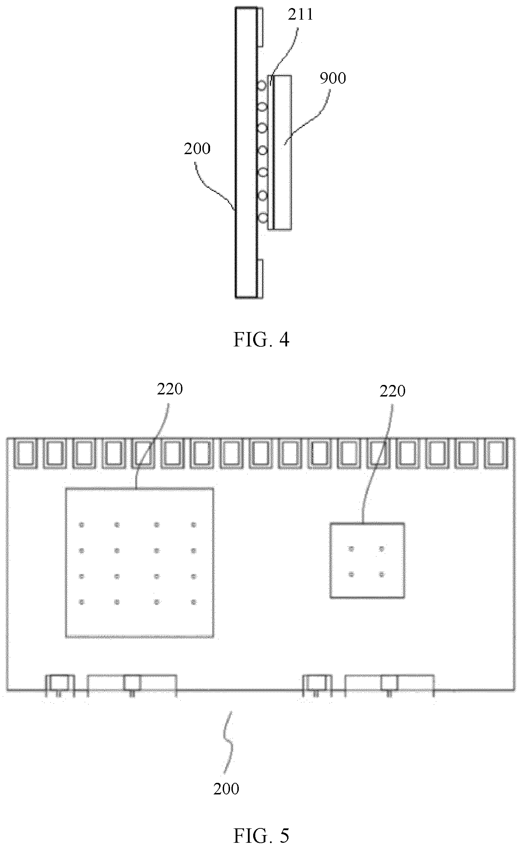

Next, refer to FIG. 4. FIG. 4 is a schematic assembly diagram of the control chip and the second substrate in the packaged structure according to an embodiment of this application. The second conductive line may be arranged on the second substrate 200, the second conductive line may be of a single-layer cable layout or a multi-layer cable layout, and a cable layout circuit may be laid out based on the control unit and an interfacing manner of the control unit. The control chip 211 is electrically connected to the second conductive line arranged on the second substrate 200. As shown in FIG. 4, the control chip 211 may be mounted onto the second substrate 200 in a bond pad flip manner, that is, a surface that is of the control chip 211 and that has a pin is disposed towards the second substrate 200, and the pin is electrically connected to the second conductive line on the second substrate 200. In this embodiment, the control chip 211 is installed in the bond pad flip manner, so that a wiring line can be shortened. This can reduce signal interference and reduce a parasitic parameter, and can further shorten a signal latency, to ensure a fast circuit response and a timely protection function response. In addition, this disposition manner can further avoid risks such as wire sagging due to a dense cable layout and a short-circuit due to wire sweep, and can also save cable layout space to help reduce a size of the second substrate 200.

It may be understood that when both the control chip 211 and the drive chip are disposed on the second substrate 200, the drive chip may also be mounted onto the second substrate 200 in the bond pad flip manner, and a pin of the drive chip is electrically connected to the second conductive line on the second substrate 200. The control chip 211 receives an external input signal and an internal feedback signal. After the signals are processed by the control chip 211, processed signals may be sent to the drive chip by using the second conductive line, and then the drive chip sends the signals to the power chips 111 by using the second conductive line and the second connecting part 400.

In the foregoing solution, both the control chip 211 and the drive chip may be electrically connected to the second substrate 200 by using the second conductive line on the second substrate 200. Therefore, no external connecting wire needs to be disposed on the second substrate 200, so that product requirements for high integration, high reliability, intelligence, and miniaturization can be met. From a process perspective, device investment costs can also be reduced, thereby improving production efficiency and a product yield.

As an optional solution, a heat dissipation element 900 may be installed on a surface that is of the control chip 211 and that faces away from the second substrate 200. Heat generated by the control chip 211 during working may be dissipated to the outside by using the heat dissipation element 900, thereby helping ensure performance and a service life of the control chip 211. When both the control chip 211 and the drive chip are disposed on the second substrate 200, a heat dissipation element 900 may also be installed on a surface that is of the drive chip and that faces away from the second substrate 200. The heat dissipation element 900 may be installed on the back of the control chip 211 or the drive chip through adhering. The heat dissipation element 900 may be specifically a heat dissipation patch. A graphite sheet or the like may be used as the heat dissipation patch.

Next, refer to FIG. 5. FIG. 5 is a schematic diagram of a structure of the first surface of the second substrate in the packaged structure according to an embodiment of this application. As shown in FIG. 5, chip carriers 220 may be further disposed corresponding to installation positions of the control chip and the drive chip on the second substrate 200, and the chip carriers 220 are disposed on the first surface of the second substrate 200. The chip carrier 220 includes a plurality of bumps, configured to be interconnected to pins of the control chip or the drive chip, to facilitate fast installation of the control chip and the drive chip. A quantity of bumps included in the chip carrier 220 and a bump distribution status may be set through matching based on an installed chip.

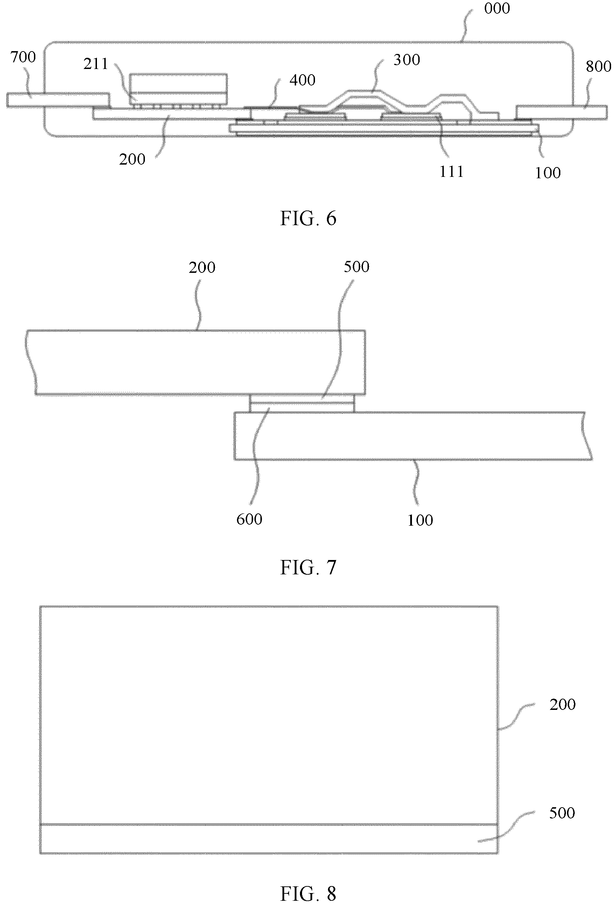

Refer to FIG. 6 together. FIG. 6 is a schematic diagram of a connection relationship between the first substrate and the second substrate in the packaged structure according to an embodiment of this application. As shown in FIG. 6, in the first direction, the second substrate 200 has a first end away from the first substrate 100. A first lead part 700 may be disposed in a region that is on the first surface of the second substrate 200 and that is close to the first end. The first lead part 700 is electrically connected to the second conductive line arranged on the second substrate 200, to be electrically connected to the control chip 211 and the drive chip. The control chip 211 may receive an external control signal by using the first lead part 700. One end of the second connecting part 400 is connected to the first surface of the second substrate 200, and is electrically connected to the control chip 211 and the drive chip by using the second conductive line. The power chips 111 are installed on the first surface of the first substrate 100. It should be noted that the first surface of the first substrate 100 is disposed on a same side as the first surface of the second substrate 200. In addition, in the first direction, the first substrate 100 has a second end away from the second substrate 200, a second lead part 800 may be disposed in a region that is on the first surface of the second substrate 200 and that is close to the second end, and the second lead part 800 is electrically connected to the first conductive line arranged on the first substrate 100, to be electrically connected to the power chips 111.

During specific implementation, a bare copper frame or an electroplated frame may be used for the lead part. A shape of an end part of the lead part may be a planer shape, or may be a step shape with a bend.

In a specific application scenario, the second lead part 800 may be connected to an external power supply battery and an external load. During specific implementation, the second lead part 800 may have three wiring terminals. Two wiring terminals may be respectively connected to a positive electrode and a negative electrode of the battery, and the other wiring terminal may be connected to the load as an output terminal.

Refer to FIG. 7 together. FIG. 7 is a schematic diagram of a disposition position of a soldering part in the packaged structure according to an embodiment of this application. As shown in FIG. 7, the connection relationship between the second substrate 200 and the first substrate 100 may be that the second substrate 200 is stacked on the first substrate 100. In the first direction, an end that is of the second substrate 200 and that is close to the first substrate 100 may be stacked on the first surface of the first substrate 100, and the second substrate 200 may be disposed in parallel to the first substrate 100. The second substrate 200 may be physically connected to the first substrate 100 in a soldering manner, so that the two substrates structurally become a whole. During specific implementation, a first soldering part 500 may be disposed on the second surface of the second substrate 200, and a second soldering part 600 may be disposed on the first surface of the first substrate 100. The second substrate 200 can be fastened to the first substrate 100 only by soldering the first soldering part 500 to the second soldering part 600.

In some other embodiments, an end that is of the second substrate 200 and that is close to the first substrate may be alternatively stacked under a second surface of the first substrate 100. When the two substrates are connected in a soldering manner, a first soldering part 500 may be disposed on the first surface of the second substrate 200, and a second soldering part 600 may be disposed on the second surface of the first substrate 100.

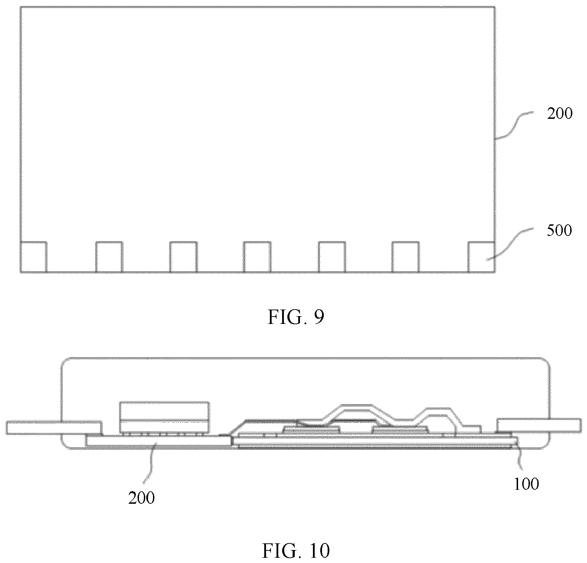

Next, refer to FIG. 8 and FIG. 9. FIG. 8 is a schematic diagram of a structure of the soldering part in the packaged structure according to an embodiment of this application. FIG. 9 is a schematic diagram of another structure of the soldering part in the packaged structure according to an embodiment of this application. During specific implementation, as shown in FIG. 8, the first soldering part 500 and the second soldering part may be in a strip shape. Alternatively, as shown in FIG. 9, the first soldering part 500 and the second soldering part each may be formed by arranging a plurality of soldering bumps. When the first substrate is assembled to the second substrate 200, a position of the first soldering part 500 may be enabled to correspond to that of the second soldering part, to complete soldering of the two substrates. When both the first soldering part 500 and the second soldering part are in a strip shape, or when one of the first soldering part 500 and the second soldering part is in a strip shape and the other soldering part is formed by arranging a plurality of soldering bumps, alignment difficulty between the first soldering part 500 and the second soldering part is relatively low. When the first soldering part 500 and the second soldering part each are formed by arranging a plurality of soldering bumps, a quantity of soldering bumps of the first soldering part 500 may be the same as a quantity of soldering bumps of the second soldering part, and there may be a same spacing between adjacent soldering bumps, so that soldering bumps of the first soldering part 500 may be disposed in a one-to-one correspondence with soldering bumps of the second soldering part, thereby more reliably connecting the first soldering part 500 to the second soldering part.

With reference to the schematic diagram of the connection relationship between the first substrate and the second substrate in the packaged structure according to the embodiment of this application in FIG. 6, in an embodiment, the whole formed by connecting the first substrate 100 and the second substrate 200 is disposed in a housing 000, so that the signal part and the power part are packaged together by using the housing 000. The second surface of the first substrate 100, that is, an opposite surface of a surface that is of the first substrate 100 and on which the power chips 111 are disposed may be completely or partially exposed to the outside of the housing 000. A specific implementation may be disposing a notch in a region that is on the housing 000 and that corresponds to the second surface of the first substrate 100. The back of the control chip 211, that is, the surface that is of the control chip 211 and on which the heat dissipation element may be installed may be completely or partially exposed to the outside of the housing 000. In other words, the heat dissipation element on the back of the control chip 211 may be completely or partially exposed. Specifically, a notch may be disposed in a region that is on the housing 000 and that corresponds to the control chip 211. Likewise, when both the control chip 211 and the drive chip are installed on the second substrate 200, the heat dissipation element on the back of the drive chip may also be completely or partially exposed. Specifically, a notch may be disposed in a region that is on the housing 000 and that corresponds to the drive chip. The notch may be integrally formed during formation of the housing 000 according to a preset design, or may be formed by removing a material based on a specific corresponding region after the housing 000 is formed.

Based on the foregoing description, the first connecting part 300 and the second connecting part 400 are wrapped in the housing 000. A pin part that is of the first lead part 700 and that is connected to the second substrate 200 and a pin part that is of the second lead part 800 and that is connected to the first substrate 100 may also be wrapped in the housing 000.

During specific implementation, the housing 000 may be formed through injection molding or potting of an epoxy molding compound (epoxy molding compound, EMC). This material has a strong capability of resisting a high temperature and aging, and has relatively low costs. A coefficient of thermal expansion of the epoxy molding compound is optionally 9×10⁻⁶/°C to 17×10⁻⁶/°C. Within this range, overall warpage of the packaged structure can be conveniently controlled, thereby ensuring installation flatness and reliability of the packaged structure.

In addition, external heat sinks may be further disposed on the second surface of the first substrate 100, the back of the control chip 211, and the back of the drive chip that are exposed to the outside of the housing 000, to enhance an overall heat dissipation capability of the packaged structure. During specific implementation, the heat sink may be a heat dissipation metal plate of an air-cooled heat sink or a water-cooled heat sink. It should be noted that the heat dissipation element on the back of the control chip 211 and the heat dissipation element on the back of the drive chip may exist together with the heat sinks.

FIG. 10 is a schematic diagram of another connection relationship between the first substrate and the second substrate in the packaged structure according to an embodiment of this application. As shown in FIG. 10, the connection relationship between the second substrate 200 and the first substrate 100 may be alternatively that the second substrate 200 is disposed against the first substrate 100. During specific implementation, in the first direction, an end surface of an end that is of the second substrate 200 and that is close to the first substrate 100 abuts against an end surface of an end that is of the first substrate 100 and that is close to the second substrate 200, thereby connecting the second substrate 200 to the first substrate 100. Similarly, the second substrate 200 may be physically connected to the first substrate 100 in a soldering manner, so that the two substrates structurally become a whole. During specific implementation, a first soldering part may be disposed on the end surface of the second substrate 200, and a second soldering part may be disposed on the end surface of the first substrate. The second substrate 200 can be fastened to the first substrate 100 only by soldering the first soldering part to the second soldering part.

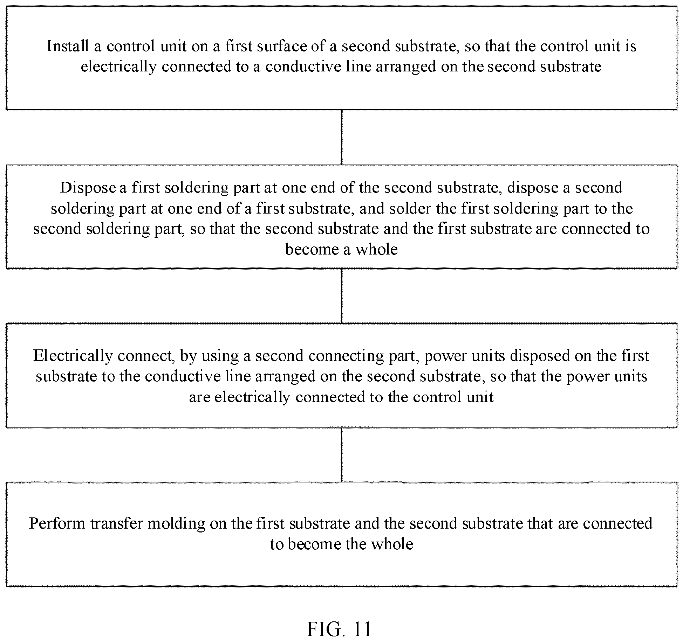

FIG. 11 is a flowchart of a manufacturing method for a packaged structure according to an embodiment of this application. The packaged structure shown in FIG. 6 is used as an example below to describe a manufacturing method for the packaged structure.

First, a plurality of power chips 111 are installed on a first substrate 100 in a plurality of rows in a first direction. The power chip 111 may be installed on a first surface of the first substrate 100 in a bond pad up manner. A control chip 211 and a drive chip are installed on a second substrate 200. The control chip 211 and the drive chip may be installed on a first surface of the second substrate 200 in a bond pad flip manner, and the control chip 211 and the drive chip are electrically connected by using a second conductive line on the second substrate 200.

Solder is printed on an end that is of the first substrate 100 and that is in the first direction, the solder is printed on an end that is of the second substrate 200 and that is in the first direction, and the end that is of the first substrate 100 and on which the solder is printed is soldered to the end that is of the second substrate 200 and on which the solder is printed, so that the first substrate 100 and the second substrate 200 form a whole.

When solder paste is used as the solder, the first substrate 100 and the second substrate 200 that are connected to become the whole may be placed in a reflow oven for reflow soldering. When sintered silver is used as the solder, the first substrate 100 and the second substrate 200 that are connected to become the whole may be placed in an oven for high temperature baking, to enhance connection stability between the first substrate 100 and the second substrate 200. In some other embodiments, high thermal conductivity silver paste, electroless nickel/immersion gold (electroless nickel/immersion gold, ENIG), plated nickel, plated gold, or the like may be alternatively used as the solder.

In the first direction, power chips 111 in a same row are electrically connected to each other by using a first connecting part 300.

The power chips 111 are electrically connected to the second conductive line on the second substrate 200 by using a second connecting part 400, to electrically connect the power chips 111 to the control chip 211 and the drive chip.

A first lead part 700 is electrically connected to an end that is of the second substrate 200 and that is away from the first substrate 100, and a second lead part 800 is electrically connected to an end that is of the first substrate 100 and that is away from the second substrate 200.

Plastically packaging is performed on the first substrate 100 and the second substrate 200 that are connected to become the whole, so that plastically packaging is performed on the first substrate 100, the second substrate 200, the power chips 111, the control chip 211, the drive chip, the first connecting part 300, the second connecting part 400, a pin part that is of the first lead part 700 and that is connected to the second substrate 200, and a pin part that is of the second lead part 800 and that is connected to the first substrate 100. For a component or a region that requires heat dissipation, for example, plastically packaging regions corresponding to a second surface of the first substrate 100, the back of the control chip 211, and the back of the drive chip, a plastically packaging compound may be removed after the plastically packaging, to expose the heat dissipation surfaces, so that external heat sinks can be installed. During specific implementation, the first substrate 100 and the second substrate 200 that are connected to become the whole may be placed in a plastically packaging mold, the plastically packaging compound in a molten state may be injected into the plastically packaging mold to wrap the foregoing parts on which plastically packaging needs to be performed, and a part obtained after the plastically packaging is placed in an oven for baking and curing and then an extra spillage part is removed.

In addition, the manufacturing method may further include other steps. Examples are as follows:

After the plastically packaging, the packaged structure is preliminarily cleaned, and specifically, may be cleaned by using water-based solder in cooperation with pure water, or by using chemical solder in cooperation with a chemical agent. After the preliminary cleaning, plasma cleaning may be further performed to remove foreign matters on a surface of the plastically packaging structure, thereby enhancing a plastically packaging binding force.

After the plastically packaging, for pins that are of the first lead part 700 and the second lead part 800 and that are exposed to the outside of the plastically packaging compound, extra parts are cut off, and the pins are formed.

The pin parts that are of the first lead part 700 and the second lead part 800 and that are exposed to the outside of the plastically packaging compound are electroplated. For example, tin may be plated on the pin parts, to facilitate subsequent wiring.

A functional test is performed on a product, and a qualified product is packed into a warehouse as required.

## Claims

1. A packaged structure, comprising:
a first substrate, wherein power units are disposed on a first surface of the first substrate; and
a second substrate, wherein a control unit is disposed on a first surface of the second substrate, the second substrate is connected to one end of the first substrate, the control unit is electrically connected to the power units, and the control unit is configured to: receive an external input signal, collect an internal sensing signal, and control the power units to work, wherein the first surface of the second substrate is disposed on a same side as the first surface of the first substrate.

2. The packaged structure according to claim 1, wherein a plurality of rows of power units are disposed on the first substrate, each row of power units comprises at least one power unit arranged in a first direction, and power units in a same row are electrically connected by using a first connecting part.

3. The packaged structure according to claim 2, wherein the first connecting part comprises a conductor, the conductor is in a multi-arch bridge shape, the conductor comprises a plurality of arch structures and a connecting part connected between adjacent arch structures, and the connecting part is electrically connected to the power unit.

4. The packaged structure according to any one of claims 1 to 3, wherein the control unit is electrically connected to the power units by using a second connecting part, and the second connecting part comprises at least one flexible printed circuit board.

5. The packaged structure according to claim 4, wherein a conductive line is arranged on the second substrate, and the flexible printed circuit board is electrically connected to the control unit by using the conductive line on the second substrate.

6. The packaged structure according to any one of claims 1 to 5, wherein one end of the second substrate is stacked on one end of the first substrate.

7. The packaged structure according to claim 6, wherein a second surface of the second substrate is connected to the first surface of the first substrate, a first soldering part is disposed on the second surface of the second substrate, a second soldering part is disposed on the first surface of the first substrate, and the first soldering part is soldered to the second soldering part; or
the first surface of the second substrate is connected to a second surface of the first substrate, a first soldering part is disposed on the first surface of the second substrate, a second soldering part is disposed on the second surface of the first substrate, and the first soldering part is soldered to the second soldering part.

8. The packaged structure according to any one of claims 1 to 5, wherein one end of the second substrate is disposed against one end of the first substrate.

9. The packaged structure according to claim 8, wherein a first soldering part is disposed on an end surface of the end that is of the second substrate and that is configured to abut against the first substrate, a second soldering part is disposed on an end surface of the end that is of the first substrate and that is configured to abut against the second substrate, and the first soldering part is soldered to the second soldering part.

10. The packaged structure according to any one of claims 1 to 9, wherein a first lead part is disposed at an end that is of the second substrate and that is away from the first substrate, and the first lead part is electrically connected to the control unit; and
a second lead part is disposed at an end that is of the first substrate and that is away from the second substrate, and the second lead part is electrically connected to the power units.

11. The packaged structure according to any one of claims 1 to 10, wherein the power unit comprises a power chip, and a surface that is of the power chip and that has a pin is away from the first substrate.

12. The packaged structure according to any one of claims 1 to 11, further comprising a housing, wherein the housing has accommodation space inside, and the first substrate and the second substrate are located inside the housing.

13. The packaged structure according to claim 12, wherein a region that is on the housing and that corresponds to the second surface of the first substrate has a first notch; and
a region that is on the housing and that corresponds to the control unit has a second notch.

14. The packaged structure according to claims 1 to 13, wherein a first heat sink is disposed on the second surface of the first substrate; and
a second heat sink is disposed on a surface that is of the control unit and that faces away from the second substrate.

15. An electric power control system, comprising the packaged structure according to claims 1 to 14, wherein the packaged structure is configured to convert a direct current of a battery into an alternating current to supply the alternating current to a power apparatus.

16. A manufacturing method for a packaged structure, comprising:
installing a control unit on a first surface of a second substrate, so that the control unit is electrically connected to a conductive line arranged on the second substrate;
disposing a first soldering part at one end of the second substrate, disposing a second soldering part at one end of a first substrate, and soldering the first soldering part to the second soldering part, so that the second substrate and the first substrate are connected to become a whole;
electrically connecting, by using a second connecting part, power units disposed on the first substrate to the conductive line arranged on the second substrate, so that the power units are electrically connected to the control unit; and
plastically packaging the first substrate and the second substrate that are connected to become the whole.
